# EUROPEAN PATENT SPECIFICATION

(11) **EP 2 626 886 B1**
(45) Date of publication and mention of the grant of the patent: **05.04.2017**
(21) Application number: 13154508.9
(22) Date of filing: 08.02.2013
(51) Int. Cl.: H01J 37/28, G01N 1/42

(54) **Forming a vitrified sample for an electron microscopy**
Formen einer schockgefrorenen Probe für ein Elektronenmikroskop
Formation d'un échantillon vitrifié pour la microscopie électronique

(30) Priority: 13.02.2012 EP 12155112
(43) Date of publication of application: 14.08.2013
(73) Proprietor: FEI COMPANY, Hillsboro, Oregon 97124-5793 (US)
(72) Inventor: Mulders, Johannes, 5632 SB Eindhoven (NL); Schampers, Ruud, 5951 JE Belfeld (NL); Piet, Trompenaars, 5038 PK Tilburg (NL)
(74) Representative: Bakker, Hendrik

(56) References cited:
- US-A1- 2008 293 832
- "Introducing the ALTO Series (Cryo System)", , 1 January 2011 (2011-01-01), pages 1-3, XP55248766, Retrieved from the Internet: URL:http://www.jeol.co.jp/en/applications/ pdf/sm/470_en.pdf [retrieved on 2016-02-09]
- CARTWRIGHT J H E ET AL: "Ice films follow structure zone model morphologies", THIN SOLID FILMS, ELSEVIER-SEQUOIA S.A. LAUSANNE, CH, vol. 518, no. 12, 2 April 2010 (2010-04-02), pages 3422-3427, XP026946883, ISSN: 0040-6090, DOI: 10.1016/J.TSF.2009.11.076 [retrieved on 2009-12-03]

## Description

The invention relates to a method of forming an image of a vitrified sample, the method comprising:
- Providing an aqueous solution comprising sample material,
- Spraying the aqueous solution on a cryogenic surface, the surface on which the solution is sprayed having a cryogenic temperature, more specifically a cryogenic temperature below 165 K, as a result of which the aqueous solution cools fast enough to solidify to form a vitrified sample,
- ,
- Forming an image of the sample material in an evacuated sample chamber of a charged particle microscope.

Such a method is known US application publication US2008/293832A1 to Canon.

When studying (imaging, analyzing) a sample in a transmission electron microscope (TEM) a beam of energetic electrons with a selectable energy of, for example, between 60 keV and 300 keV, irradiates a sample. The sample should be sufficiently thin so that a large portion of the electrons pass through the sample, to be imaged/detected. The imaging may for example comprise imaging the electrons on a fluorescent material, or imaging the electrons on a detector comprising, for example, a CCD or CMOS chip.
As known to the skilled person similar imaging or analysis can be performed by scanning a beam of energetic charged particles (electrons, ions, clusters) over the sample and observing the radiation emerging from the sample in response to the impinging charged particles. Such a study is then performed in the evacuated sample chamber of an apparatus equipped with a Scanning Electron Microscope (SEM) column and/or a Focused Ion Beam (FIB) column.

For biological material it is necessary to study for example tissue in the harsh environment of an electron microscope, i.e. in vacuum and at high radiation levels. To that end the sample material is often cooled to a cryogenic temperature. Cooling biological material to cryogenic temperature involves more than just cooling the material, as cooling typically results in damage of the sample material (cells, bacteria, viruses, or the like) by the formation of ice needles. As known to the person skilled in the art the sample material should be embedded in vitrified ice, which is an amorphous form of ice. Vitrified ice is formed by cooling an aqueous solution at a rate in the order of 10⁵ K/s to a temperature of less than the glass transition temperature of approximately 165 K. As an alternative vitrification is performed at a pressure of approximately 2100 bar at a cooling rate of "only" approximately 600 K/s. As the cooling rate is lower, thicker vitrified samples can be formed in this so-called High Pressure Freezing (HPF) process.

A cryogenic sample in vitrified ice is for example formed by applying a thin layer of an aqueous solution on a carrier, for example a TEM grid. Excess water is then removed by blotting, and the remaining carrier with the aqueous solution is then plunged in a cryogenic fluid, such as ethane or liquid nitrogen. An example of an apparatus to perform this method is commercially available under the name Vitrobot, and manufactured by FEI Company, Hillsboro, OR, USA.

In the known method of Canon, for example in its figure 6 and accompanying description [0142]-[0148], an apparatus is described with a sample chamber (24), an electron column (22) and a pre-processing chamber (11) with metallization unit (12) and spray unit (7). A sample holder (2a) is equipped to move a sample from the pre-processing chamber to the sample chamber. A sample (1) is introduced in the pre-processing chamber on the sample holder, after which the pre-processing chamber is repeatedly purged with dry nitrogen, and then evacuated. Then the sample holder is cooled, after which the liquid sample material is sprayed on the sample holder and solidifies (vitrifies), after which the sample is metallized. Then a valve between the pre-processing chamber and the sample chamber is opened and the sample on the sample holder is introduced on the sample chamber, to be inspected with the electron beam column.

The invention intends to provide an alternative method to form cryogenic samples.

To that end the method according to the invention is characterized in that the surface on which the solution is sprayed is positioned in the sample chamber of the charged particle apparatus, and that the droplets are sprayed on the cryogenic surface while in the evacuated sample chamber of the charged particle microscope.

The invention is based on the insight that, when spraying small droplets on a cryogenic surface, the droplets cool fast enough to solidify in the form of amorphous ice, thus forming a vitrified sample. As this is done *in situ* (in the sample chamber of the charged particle microscope) the sample is prepared quick and in an environment where no ice can grow on the now cryogenic sample.

It is noted that the internet publication "Introducing the ALTO Series (Cryo System)" [-1-], January 1st 2011, pages 1-3 (http://www.jeol.co.jp/en/applications/pdf/sm/470 en.pdf) discloses an electron microscope with a temperature controlled cryogenic stage and a cooled preparation chamber. However, this internet publication does not mention spraying droplets on the stage.

It is noted that it is estimated that for droplets with a diameter of more than 10 µm, the cooling of at least part of the droplet is too slow to form vitrified ice. Preferably a part of the droplets should thus have a diameter of less than 10 µm, more preferably less than 2 µm. The exact maximum size of the droplets depends on the presence of, for example, cryo-protectants, such as glycerol, glucol, or certain anti-freeze proteins. In the presence of such a cryo-protectant the diameter may be larger.
It is noted that at impact the presumably round droplet deforms to a shape that has a larger surface-to-volume ratio and less 'thickness', thus enhancing the cooling rate.

In an embodiment of the method according to the invention the aqueous solution is sprayed on a sample holder, the sample holder kept at a cryogenic temperature by contact with a cryogenic holding device.

The sample holder, for example a TEM grid or a SEM stub holder, is preferably held by a cryogenic holding device, as a result of which the sample holder is cooled to a cryogenic temperature. In this way a sample can be prepared on the sample holder, and then the sample holder can be removed from the holding device, to be exchanged for another sample holder for forming another sample.

The sample holder can be attached to the holding device with, for example, electrostatic forces. However, other attachment methods, such as clamping, may be used as well.

In an embodiment the sample holder is the sample holder used in a SEM (often referred to as a stub holder) or a so-named grid for a TEM.

In another embodiment the vitrified sample is machined by slicing with, for example, a cryoultramicrotoom or by milling with a focused ion beam, thereby forming a sample in the form of a lamella. Samples in the form of a thin lamella's, with a thickness of less than 1 µm, more preferably less than 200 nm, are used in Transmission Electron Microscopy. The thus formed lamella's may be mounted on a sample holder by attaching it to a manipulator that transports it to, for example, a TEM sample holder (a "grid") and then attach it to the sample holder by, for example, beam induced deposition (BID).

In yet another embodiment of the method according to the invention the aqueous solution is sprayed from a mixer. Such a mixer is known from "Monolithic microfluidic mixing-spraying devices for time-resolved cryo-electron microscopy", Z. Lu et al., J. Struct. Biol. 168 (2009), pages 388-395, further referred to as Lu [-2-]. Such a mixer enables the mixing of chemicals with the aqueous solution milliseconds before the sample material is sprayed on the cryogenic surface, where the chemical reactions are arrested.
This mixing may especially be attractive for embedding cells (or parts thereof) in water with cryoprotectant. When adding the cryo-protectant to the water just before spraying, the cryo-protectant does not have time to enter the cell, and therefore the cell is seen in its natural condition, even when the water outside the cell contains a cryo-protectant.

In still another embodiment of the method according to the invention the sample material is sprayed on a solid or liquid that melts, evaporates or sublimates at a temperature below the glass transition temperature, the solid or liquid together with the sample material is put on a sample carrier, and after putting the solid or liquid together with the sample material on the sample carrier the solid or liquid is removed.

Removal can take the form of evaporation, sublimation, or removing the (cryogenic) liquid by e.g. blotting.

When working in an environment of dry nitrogen, the aqueous solution can be sprayed on liquid nitrogen, preferably non-boiling. Similarly ethane can be used, in either an environment of dry ethane or nitrogen.

It is noted that this is not an embodiment as this may be incompatible with a vacuum environment, as typically high vapor pressure occurs during removal of the solid or liquid.

The invention is now elucidated using figures, in which identical reference numerals indicate corresponding features.

To that end:
Figure 1 schematically shows a charged particle apparatus equipped with a Gas Injection System,
Figure 2A, 2B and 2C show SEM images of vitrified sample material.
Figure 3 shows a shallow cup-shaped TEM sample holder for use with embodiment 5

### Embodiment 1

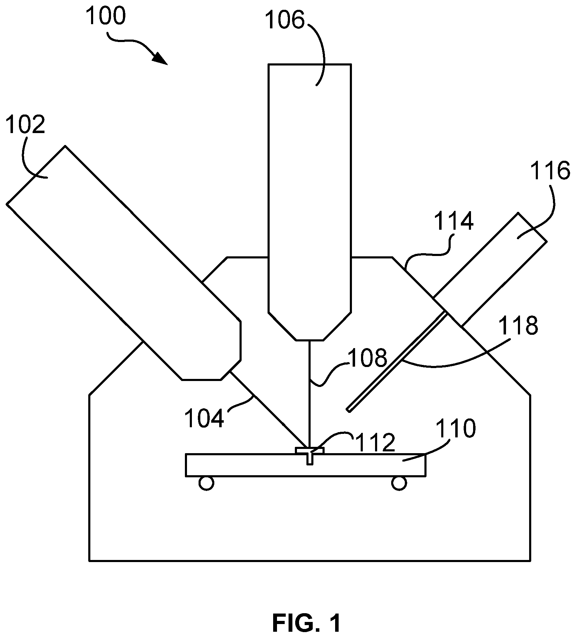

Figure 1 schematically shows a first embodiment. A charged particle apparatus 100 equipped with a focused ion beam column (FIB column) 102 for producing a beam of ions 104 and a scanning electron microscope column (SEM column) 106 for producing a beam of electrons 108. Such a charged particle apparatus is commercially available as, for example, a 3D Cryo DualBeam™ apparatus, and sold by FEI Company, Hillsboro, OR, USA. An application note describing the apparatus is available on the internet, see [-3-].

Such an instrument is equipped with a sample stage 110 that is equipped to be held at a cryogenic temperature, typically around -160°C. The sample stage is equipped to hold sample holders 112 (also known as "stubs") on which a sample is sprayer or otherwise mounted. The stage is positioned in an evacuable sample chamber 114. A sample mounted on the stage can be machined (milled, sputtered) by the focused ion beam 104 produced by the FIB column, and imaged using the focused electron beam 108. Secondary radiation emerging from the sample as a result of the impinging charged particles is detected by one or more detectors (not shown), such as a secondary electron detector or an X-ray detector.

Where prior art methods required that a sample was loaded in the vacuum chamber by placing the sample mounted on a sample holder on the sample stage, the method according to the invention forms the sample "in-situ" by spraying a jet of small droplets on the cryogenic sample holder 112

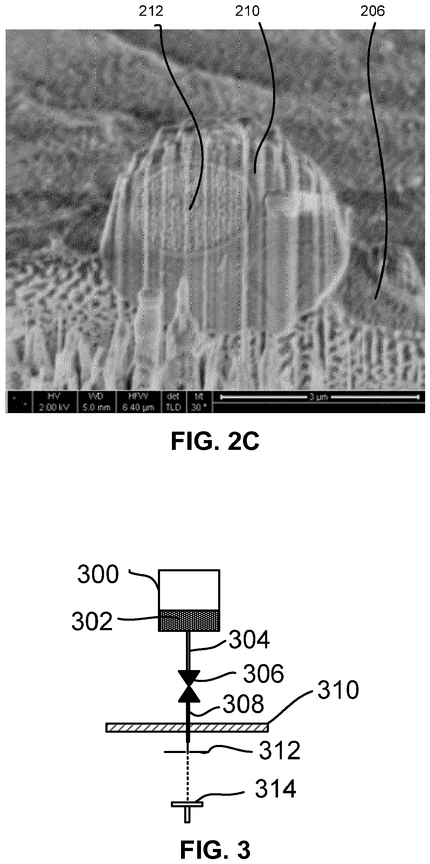

First experiments used a modified Gas Injection System (GIS) 116 as described in US patent number US5,435,850 to FEI Co, Hillsboro, USA. Such a GIS incorporates a hollow metal needle 118 with a diameter of between 1 and 2 millimeter and one end is positioned close to the sample stage. The other end is via a plunger connected to a heatable volume (the "crucible") where normally the material to be injected resides at a pressure between 0.1 to 100 mbar (typically less than 1 mbar). It is noted that the material to be injected is turned in a gaseous product by evaporation or sublimation. The plunger is opened to inject gas, and closed to stop doing so. The GIS was modified, the modifications involving:
- locating an aperture with a diameter of 200 µm between the plunger and the crucible
- the needle was removed from the sample holder
- the crucible plunger area was loaded with a suspension comprising cells of baker's yeast (ca 1 ml)
The resultant modified GIS is schematically shown in figure 3. Crucible 300 is partly filled with solution 302 comprising sample material. Tube 304 connects the crucible with a valve 306. Through this valve liquid enters a tube 308 that feeds through the vacuum wall of the electron microscope 310. The liquid is then atomized when passing through a 200 µm aperture in diaphragm 312. It is noted that a pressure difference is present between the crucible and the aperture in the diaphragm, as the crucible is at an internal pressure of between 0.1 to 100 mbar, while the aperture connects to the evacuated volume in which the sample holder resides. The atomized suspension is then sprayed on sample holder 314, that is kept at a temperature of, for example, -160°C. The distance between the aperture in diaphragm 312 and sample holder 314 is approximately 5 cm.
These modifications enabled the GIS to spray small volumes of the suspension by shortly opening and almost immediately closing the GIS. As a result of this a small amount of cell suspension formed of many tiny droplets was "sneezed" upon the sample holder.

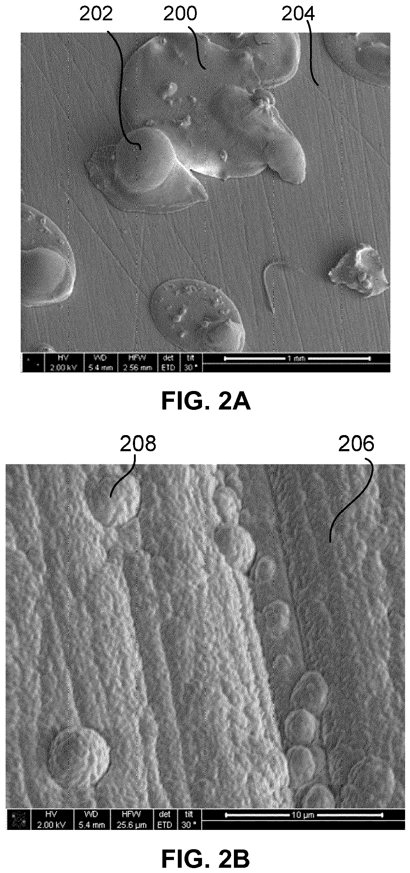

The result of the spraying is shown in figure 2A and (more detailed) figure 2B. Figure 2A shows a field of view of approximately 2½ x 2½ mm². It shows a few large droplets 200 and 202. Droplet 200 seems to be flattened at impact. The area 204 between the obviously covered part turns out to be covered by a very thin layer of ice, as shown in figure 2B. Figure 2B shows a field of view of 25 x 25 µm², showing a thin layer 206 of ice in which cells 208 are embedded. Figure 2C shows an even further enlargement showing a field of view of approximately 6 x 6 µm², in which, using a focused ion beam, a part of a cell is removed so that a cross section is visible. It shows the amorphous ice matrix 206 and the cross section 210 of a cell, showing among other its nucleus 212. No sign of ice needles is found.
It is expressly noted that these are the results of first, very crude, experiments, and that the limitations of these pictures should not be taken as limitations of the methods according to the invention.

### Embodiment 2

In a second embodiment the suspension is not sprayed on the cold surface through a needle, but by a mixer like the one described by Lu [-2-] in its figure 1 and accompanying text. In this way changes in the fluid can be made shortly before spraying the suspension on the cryogenic surface.
It is noted that also a heater can be incorporated to hold the suspension in the mixer at a desired temperature of, for example, 37°C, or a desired lower or higher temperature.
It is further noted that the use of a gas for atomizing the fluid (suspension) implies that this embodiment is suited for use in a protective atmosphere and less suited for use in a vacuum. However, provided that the pressure bursts of the gas atomizing the suspension are modest and the vacuum system is tolerant to pressure bursts, such as used in for example an Environmental SEM, this embodiment may be used to spray the suspension on the sample holder in situ, that is: in the evacuated sample chamber of an Environmental SEM or another charged particle microscopy instrument equipped to deal with such pressures.

### Embodiment 3

In a third embodiment the suspension is sprayed on the surface using electrospraying, as described by, for example, White [-6-]. Although White [-6-] proposes electro-spraying in a protective environment only, the person skilled in the art will realize that this can take place in a vacuum as well, i.e. in the specimen chamber of an electron microscope or, more general, of a charged particle microscopy apparatus.

It is noted that the opening from which the suspension emerges can be a nozzle mounted on the mixer of embodiment 2, leading to a hybrid embodiment.

### Embodiment 4

In this embodiment the aqueous solution is sprayed on a cryogenic liquid or cryogenic solid. The liquid or solid is characterized in that it can be removed at a temperature below the glass transition temperature of water. This removal may be done by evaporating the fluid, by sublimation, by draining, or any other way. The frozen droplets can then be left on for example a -originally submerged- sample holder, or be scooped from the liquid. In methods not forming part of the invention, the cryogenic liquid can be for example liquid nitrogen or ethane.

### Embodiment 5

This embodiment is alike to embodiment 4, but here a TEM sample grid comprising a grid with a thin film is kept on top of the fluid.

TEM carbon grids are commercially available where a carrier grid is used to support a carbon film of only several micrometers thick, or even comprising a graphene film (see for example the brochure of Graphene Laboratories Inc., Calverton, NY, USA. As such a thin carbon film hardly interacts with a beam of electrons, a sample placed on this film can be well imaged. Similarly grids with a thin Si₃N₄ film are commercially available.

The problem when using such a grid for the method according to the invention is that the heat capacity of the thin film is insufficient to cool the droplets to a temperature below the glass transition temperature.

Embodiment 5 solves this by keeping one side of the film in contact with a cryogenic liquid. In this way the thin carbon film is kept at a low temperature even when larger amounts of water are sprayed on the film.

It is noted that similarly the grid can be placed on a cold metal surface, but that often the film is then frozen to the metal surface.

It is further noted that the grid can be formed as a shallow cup, minimizing the risk that some of the cryogenic liquid sloshes over the film. Such a cup can be made to float upon the cryogenic liquid.

### Embodiment 6

In a sixth embodiment a cryogenic surface is covered by vitrified sample material by one of the methods described earlier, after which samples, such as lamella, are formed from the vitrified sample material by excavating the samples or lamella using a focused ion beam and freeing the samples or lamellas from the cryogenic surface and transporting them to a (cryogenic) sample carrier, for example a TEM grid..

It is noted that prolonged spraying of the solution on the cryogenic surface can lead to a thick layer of sample material from which the lamella can be excised.

It is further noted that other techniques, such as fluorescent techniques, can be used to identify areas of interest on the layer of sample material, after which lamella or samples can be taken from these areas. We claim as follows:

### Literature:

[-1-] JEOL Application Data Sheet "Introducing the ALTO Series (Cryo System)" [-1-], January 1st 2011, pages 1-3, internet publication, (http://www.jeol.co.jp/en/applications/pdf/sm/470 en.pdf) [-2-] "Monolithic microfluidic mixing-spraying devices for time-resolved cryo-electron microscopy", Z. Lu et al., J. Struct. Biol. 168 (2009), pp 388-395.
[-3-] Application note 3D Cryo-DualBeam™, FEI Co., Hillsboro, OR, USA: http://www.fei.com/uploadedFiles/Documents/Content/2006_06_3D_Cyro_DualBeam _mb.pdf
[-4-] Gas Injection System, US patent No. US5,435,850.
[-5-] Brochure of Graphene Laboratories Inc, Calverton, NY, USA: http://www.graphene-supermarket.com/images/XC/TEM/GrapheneTEMgrids-General%20info.pdf
[-6-] "A second generation apparatus for time-resolved electron cryo-microscopy using stepper motors and electrospray", H.D. White et al., J. Struct. Biol 144 (2003), pp 246-252,

## Claims

1. Method of forming an image of a vitrified sample, the method comprising:
• providing an aqueous solution comprising sample material,
• spraying droplets of the aqueous solution on a surface (112), the surface on which the solution is sprayed having a cryogenic temperature, more specifically a cryogenic temperature below 165 K, as a result of which the aqueous solution cools fast enough to solidify to form a vitrified sample, and
• forming an image of the vitrified sample in an evacuated sample chamber (114) of a charged particle microscope (100),
• **characterized in that** the droplets are sprayed on the surface while in the evacuated sample chamber of the charged particle microscope,
as a result of which the vitrified sample is formed *in situ* on the surface at the moment the droplets hit the surface.

2. The method of claim 1 in which the solution comprises proteins, cells or parts of cells.

3. The method of claim 1 or claim 2 in which at least part of the droplets have a diameter of less than 10 µm, more specifically less than 2 µm, as a result of which the at least part of the droplets form the vitrified sample.

4. The method of any of the preceding claims in which the aqueous solution is sprayed on a sample holder (112), the sample holder kept at a cryogenic temperature by contact with a cryogenic holding device.

5. The method of claim 4 in which the cryogenic holding device attracts the sample holder by electrostatic forces.

6. The method of any of the preceding claims further comprising machining the vitrified sample by slicing with a cryoultramicrotoom or by milling with an ion beam (104), thereby forming a sample in the form of a lamella.

7. The method of any of the preceding claims in which the aqueous solution is sprayed from a mixer equipped to mix fluids and spray the fluid on the surface.

8. The method of any of the preceding claims in which the aqueous solution is sprayed on the surface using electro-spraying.

9. The method of any of the preceding claims in which the sample material is sprayed on a solid or liquid that evaporates at a temperature below the glass transition temperature, the solid or liquid together with the sample material is put on a sample carrier, and after putting the solid or liquid together with the sample material on the sample carrier the solid or liquid is removed.

10. The method of any of the preceding claims in which the surface is placed on the intersect of a column producing a focused beam of ions and a column producing a focused beam of electrons.

11. The method of any of the preceding claims in which multiple layers of vitrified material are deposited by spaying multiple droplets over each other.

## Patentansprüche

1. Verfahren zur Erzeugung eines Bilds einer vitrifizierten Probe, wobei das Verfahren aufweist:
- Bereitstellen einer wässrigen Lösung, die Probenmaterial aufweist;
- Sprühen von Tröpfchen der wässrigen Lösung auf eine Oberfläche (112), wobei die Oberfläche, auf die die Lösung gesprüht wird, eine Tieftemperatur, insbesondere eine Tieftemperatur unter 165 K, hat, wobei die wässrige Lösung als eine Folge davon schnell genug abkühlt, um sich derart zu verfestigen, dass sie eine vitrifizierte Probe bildet, und
- Erzeugen eines Bildes der vitrifizierten Probe in einer evakuierten Probenkammer (114) eines geladenen Teilchenmikroskops (100),
- **dadurch gekennzeichnet, dass** die Tröpfchen auf die Oberfläche gesprüht werden, während sie in der evakuierten Probenkammer des geladenen Teilchenmikroskops ist,
wobei die vitrifizierte Probe als eine Folge davon in dem Moment, in dem die Tröpfchen auf die Oberfläche auftreffen, an Ort und Stelle auf der Oberfläche erzeugt wird.

2. Verfahren nach Anspruch 1, wobei die Lösung Proteine, Zellen oder Teile von Zellen aufweist.

3. Verfahren nach Anspruch 1 oder Anspruch 2, wobei wenigstens ein Teil der Tröpfchen einen Durchmesser von weniger als 10 µm, insbesondere weniger als 2 µm hat, wobei als eine Folge davon wenigstens ein Teil der Tröpfchen die vitrifizierte Probe bilden.

4. Verfahren nach einem der vorhergehenden Ansprüche, in dem die wässrige Lösung auf einen Probenhalter (112) gesprüht wird, wobei der Probenhalter durch den Kontakt mit einer Tieftemperaturhaltevorrichtung auf einer Tieftemperatur gehalten wird.

5. Verfahren nach Anspruch 4, wobei die Tieftemperaturhaltevorrichtung den Probenhalter durch elektrostatische Kräfte anzieht.

6. Verfahren nach einem der vorhergehenden Ansprüche, das ferner die maschinelle Bearbeitung der vitrifizierten Probe durch Schneiden mit einem Tieftemperatur-Ultramikrotom oder durch Fräsen mit einem Ionenstrahl (104) aufweist, um dadurch eine Probe in der Form eines Plättchens zu erzeugen.

7. Verfahren nach einem der vorhergehenden Ansprüche, wobei die wässrige Lösung von einem Mischer gesprüht wird, der ausgerüstet ist, um Fluide zu mischen und das Fluid auf die Oberfläche zu sprühen.

8. Verfahren nach einem der vorhergehenden Ansprüche, in dem die wässrige Lösung unter Verwendung von Elektrosprühen auf die Oberfläche gesprüht wird.

9. Verfahren nach einem der vorhergehenden Ansprüche, wobei das Probenmaterial auf einen Festkörper oder eine Flüssigkeit, die unterhalb der Glasübergangstemperatur verdampft, gesprüht wird, wobei der Festkörper oder die Flüssigkeit zusammen mit dem Probenmaterial auf einen Probenträger gebracht werden, und wobei der Festkörper oder die Flüssigkeit entfernt werden, nachdem der Festkörper oder die Flüssigkeit zusammen mit dem Probenmaterial auf den Probenträger gebracht wurden.

10. Verfahren nach einem der vorhergehenden Ansprüche, in dem die Oberfläche auf dem Schnitt einer Säule, die einen fokussierten Ionenstrahl erzeugt, und einer Säule, die einen fokussierten Elektronenstrahl erzeugt, angeordnet ist.

11. Verfahren nach einem der vorhergehenden Ansprüche, in dem durch Sprühen mehrerer Tröpfchen übereinander mehrere Schichten von vitrifiziertem Material abgeschieden werden.

## Revendications

1. Procédé de formation d'une image d'un échantillon vitrifié, le procédé comprenant :
▪ la fourniture d'une solution aqueuse comprenant une matière d'échantillon,
▪ la pulvérisation de gouttelettes de la solution aqueuse sur une surface (112), la surface sur laquelle la solution est pulvérisée ayant une température cryogénique, plus spécifiquement une température cryogénique inférieure à 165 K, d'où il résulte que la solution aqueuse refroidit assez rapidement pour se solidifier pour former un échantillon vitrifié, et
▪ la formation d'une image de l'échantillon vitrifié dans une chambre d'échantillon mise sous vide (114) d'un microscope à particules chargées (100),
▪ **caractérisé en ce que** les gouttelettes sont pulvérisées sur la surface tout en étant dans la chambre d'échantillon mise sous vide du microscope à particules chargées, d'où il résulte que l'échantillon vitrifié est formé *in situ* sur la surface au moment où les gouttelettes frappent la surface.

2. Procédé selon la revendication 1, dans lequel la solution comprend des protéines, des cellules ou des parties de cellules.

3. Procédé selon la revendication 1 ou la revendication 2, dans lequel au moins une partie des gouttelettes présente un diamètre inférieur à 10 µm, plus spécifiquement inférieur à 2 µm, d'où il résulte que au moins une partie des gouttelettes forme l'échantillon vitrifié.

4. Procédé selon l'une quelconque des revendications précédentes, dans lequel la solution aqueuse est pulvérisée sur un support d'échantillon (112), le support d'échantillon maintenu à une température cryogénique par mise en contact avec un dispositif de support cryogénique.

5. Procédé selon la revendication 4, dans lequel le dispositif de support cryogénique attire le support d'échantillon par des forces électrostatiques.

6. Procédé selon l'une quelconque des revendications précédentes comprenant de plus l'usinage de l'échantillon vitrifié par tranchage avec un cryo-ultramicrotome ou par broyage avec un faisceau d'ions (104), formant par là un échantillon dans la forme d'une lamelle.

7. Procédé selon l'une quelconque des revendications précédentes, dans lequel la solution aqueuse est pulvérisée à partir d'un mélangeur équipé pour mélanger des fluides et pulvériser le fluide sur la surface.

8. Procédé selon l'une quelconque des revendications précédentes, dans lequel la solution aqueuse est pulvérisée sur la surface en utilisant une électro-pulvérisation.

9. Procédé selon l'une quelconque des revendications précédentes, dans lequel la matière d'échantillon est pulvérisée sur un solide ou liquide qui s'évapore à une température inférieure à la température de transition vitreuse, le solide ou liquide avec la matière d'échantillon est déposé sur un support d'échantillon, et après avoir mis le solide ou liquide avec la matière d'échantillon sur le support d'échantillon le solide ou liquide est éliminé.

10. Procédé selon l'une quelconque des revendications précédentes, dans lequel la surface est placée sur l'intersection d'une colonne produisant un faisceau concentré d'ions et d'une colonne produisant un faisceau concentré d'électrons.

11. Procédé selon l'une quelconque des revendications précédentes, dans lequel des couches multiples de matière vitrifiée sont déposées par pulvérisation de multiples gouttelettes les unes sur les autres.
